# EUROPEAN PATENT APPLICATION

(11) **EP 4 844 963 A2**
(43) Date of publication of application: **25.11.2026**
(21) Application number: 26165864.5
(22) Date of filing: 18.03.2026
(51) Int. Cl.: H01S 5/183, H01S 5/42

(54) **METHOD FOR FABRICATING LASER STRUCTURE AND LASER STRUCTURE THEREOF**

(30) Priority: 29.04.2025 TW 114116196
(71) Applicant: Hon Hai Precision Industry Co., Ltd., 236038 New Taipei City (TW)
(72) Inventor: CHANG, Chih-Ting, 236038 New Taipei City (TW); SHER, Chin-Wei, 236038 New Taipei City (TW); HONG, Yu-Heng, 236038 New Taipei City (TW); KUO, Hao-Chung, 236038 New Taipei City (TW); YU, Hsin-Chieh, 236038 New Taipei City (TW); YEH, Hui-Tzu, 236038 New Taipei City (TW); LIN, Chien-Lin, 236038 New Taipei City (TW); CHANG, Kuan-Yuan, 236038 New Taipei City (TW)
(74) Representative: Mewburn Ellis LLP

(57) **Abstract**

A method for fabricating a laser structure including: forming a first semiconductor layer on a conductive substrate; forming an active layer on the first semiconductor layer; forming a second semiconductor layer on the active layer; forming a dielectric layer on the second semiconductor layer; forming plural blind via holes in the second semiconductor layer; and forming an oxide insulation layer in the second semiconductor layer and the blind via holes to obtain the laser structure, in which the blind via holes extend from a top surface of the dielectric layer to a bottom surface of the second semiconductor layer, and the blind via holes expose a top surface of the active layer.

## Description

### BACKGROUND

### Technical Field

The present disclosure relates to a laser structure, and more particularly to a laser structure with annular blind via holes replacing conventional annular trenches.

### Description of Related Art

A surface-emitting laser (SEL) is a type of semiconductor laser structure with a laser beam emitted perpendicular to a top surface of the SEL. For emission efficiency and a response speed of the SEL, a current confinement layer may be arranged in the SEL, in which the current confinement layer may control a flow direction of a current of the SEL. Therefore, the current of the SEL that flows to an optical window (i.e., a predefined light emitting region) may be confined to increase a current density of the optical window, thereby allowing the SEL to emit the laser beam more easily.

### SUMMARY

In one aspect of the present disclosure, a laser structure is provided. The laser structure uses a ring configuration of blind via holes to replace conventional annular etched trenches. Therefore, it may effectively prevent failure of a component resulting from a fracture of a metal in a subsequent wiring process. The annular blind via holes of the laser structure is not limited to be fabricated by an etching process. Therefore, it may significantly reduce costs of materials and processes, and increase heat dissipation efficiency of the component. Furthermore, the annular blind via holes are not limited to be formed at a position of the optical window. The annular blind via holes may be formed at positions other than the position of the optical window. Therefore, it may achieve a quasi-planar effect to avoid a leakage current path between the blind via holes with the ring configuration, thus preventing the leakage current.

According to some embodiments of the present disclosure, a method for fabricating a laser structure is provided. The method includes: forming a first semiconductor layer on a conductive substrate; forming an active layer on the first semiconductor layer; forming a second semiconductor layer on the active layer; forming a dielectric layer on the second semiconductor layer; forming plural blind via holes in the second semiconductor layer; and forming an oxide insulation layer in the second semiconductor layer and the blind via holes to obtain the laser structure, in which the blind via holes extend from a top surface of the dielectric layer to a bottom surface of the second semiconductor layer, and the blind via holes expose a top surface of the active layer.

According to some embodiments of the present disclosure, a conductive type of the first semiconductor layer is the same as a conductive type of the second semiconductor layer.

According to some embodiments of the present disclosure, a conductive type of the first semiconductor layer is different from a conductive type of the second semiconductor layer.

According to some embodiments of the present disclosure, a conductive type of the second semiconductor layer is P type doping or N type doping in combination with a tunneling junction.

According to some embodiments of the present disclosure, the active layer separates the second semiconductor layer from the first semiconductor layer.

According to some embodiments of the present disclosure, the oxide insulation layer has first portions and second portions, and the second portions extend beyond the first portions.

According to some embodiments of the present disclosure, the second portion of the oxide insulation layer, the second semiconductor layer, and the active layer form a light emitting region.

According to some embodiments of the present disclosure, the light emitting region is between the second portions of the oxide insulation layer.

According to some embodiments of the present disclosure, the blind via holes include plural first blind via holes and second blind via holes, in which the second blind via holes are between the first blind via holes.

According to some embodiments of the present disclosure, the oxide insulation layer has first portions and second portions, and the second portions of the oxide insulation layer, the second semiconductor layer, and the active layer form a light emitting region, in which the first blind via holes surround the light emitting region.

According to some embodiments of the present disclosure, a laser structure is provided. The laser structure includes a conductive substrate, a first semiconductor layer, an active layer, a second semiconductor layer, a dielectric layer, plural blind via holes, and an oxide insulation layer. The first semiconductor layer is disposed on the conductive substrate. The active layer is disposed on the first semiconductor layer. The second semiconductor layer is disposed on the active layer. The dielectric layer is disposed on the second semiconductor layer. The blind via holes extend from a top surface of the dielectric layer to a bottom surface of the second semiconductor layer, in which the blind via holes expose a top surface of the active layer. The oxide insulation layer is in the second semiconductor layer and the blind via holes.

According to some embodiments of the present disclosure, the oxide insulation layer has first portions and second portions, and the second portions extend beyond the first portions.

According to some embodiments of the present disclosure, the second portions of the oxide insulation layer, the second semiconductor layer, and the active layer form a light emitting region.

According to some embodiments of the present disclosure, the light emitting region is between the second portions of the oxide insulation layer.

According to some embodiments of the present disclosure, the blind via holes include plural first blind via holes and second blind via holes, in which the second blind via holes are between the first blind via holes.

According to some embodiments of the present disclosure, the first blind via holes surround the light emitting region.

According to some embodiments of the present disclosure, the first blind via holes are arranged in a plurality of equilateral triangles.

According to some embodiments of the present disclosure, the first blind via holes are arranged in a plurality of N-gons, and N is a positive integer greater than 4.

According to some embodiments of the present disclosure, an arrangement of the first blind via holes defines a shape of the light emitting region.

According to some embodiments of the present disclosure, a oxide aperture of the light emitting region matches $DA ≒ R 1 - D 1 - 2 \times L 1 ,$ where DA is the oxide aperture, D1 is a diameter of the first blind via holes or the second blind via holes, and L1 is an oxide depth of the oxide insulation layer facing towards the second semiconductor layer.

According to some embodiments of the present disclosure, the first blind via holes and the second blind via holes match $D 1 < D 2 < 2 \times L 1 + D 1 ,$ where D1 is a diameter of the first blind via holes or the second blind via holes, D2 is distance between the adjacent two of first blind via holes or the adjacent two of second blind via holes, and L1 is an oxide depth of the oxide insulation layer facing towards the second semiconductor layer.

### BRIEF DESCRIPTION OF THE DRAWINGS

For a more complete understanding of the embodiments and their advantages, refer to the following description in conjunction with the accompanying drawings, in which:
FIG. 1 is a flow diagram of a method for fabricating a laser structure in accordance with some embodiments of the present disclosure.
FIGs. 2A to 2D are cross-sectional views of a laser structure at various process stages in accordance with some embodiments of the present disclosure.
FIGs. 3A and 3B are schematic diagrams of a laser structure in accordance with some embodiments of the present disclosure.
FIGs. 4A and 4B are schematic diagrams of arrangements of blind via holes of a laser structure in accordance with some embodiments of the present disclosure.

### DETAILED DESCRIPTION

The embodiments of the present disclosure are discussed in detail below. However, it should be understood that the embodiments provide many applicable concepts that can be implemented in a wide variety of specific contexts. The embodiments discussed and disclosed are for illustrative purposes only and are not intended to limit the scope of the present disclosure. As used herein, the terms "first," "second," etc., do not specifically refer to order or sequence, but are intended only to distinguish components or operations that are described in the same technical terms.

Further, spatially relative terms, such as "beneath," "below," "lower," "above," "upper," and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly. As used herein, "around," "about," "approximately," or "substantially" shall generally mean within 20 percent, or within 10 percent, or within 5 percent of a given value or range. Numerical quantities given herein are approximate, meaning that the term "around," "about," "approximately," or "substantially" can be inferred if not expressly stated.

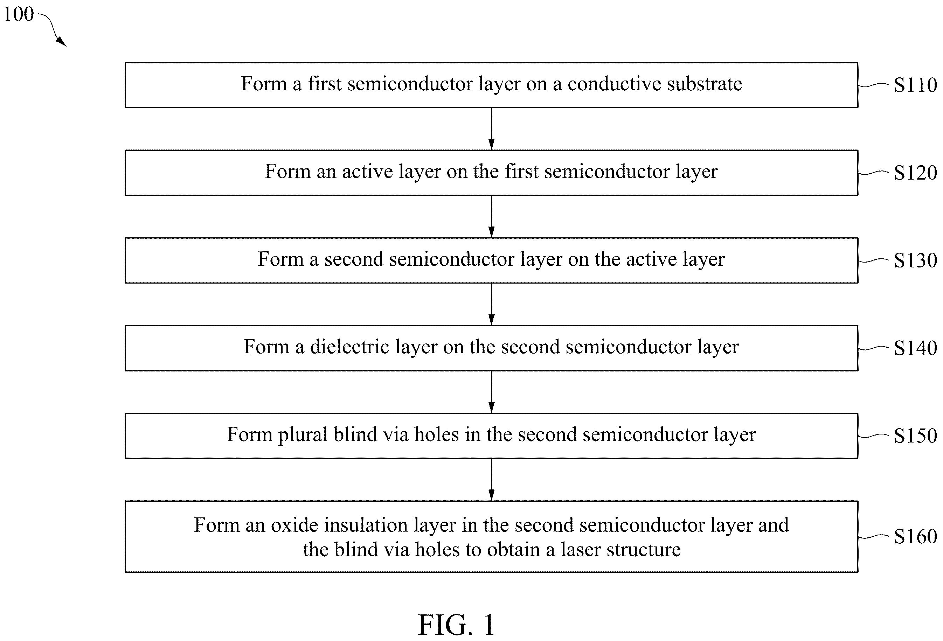

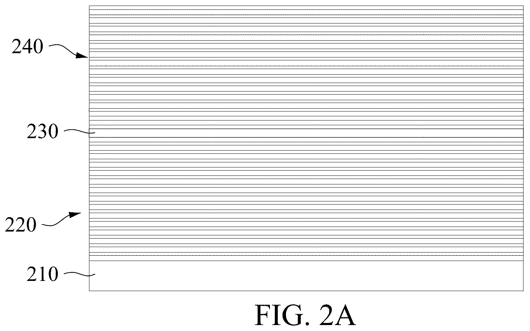

FIG. 1 is a flow diagram of a method 100 for fabricating a laser structure 200 in accordance with some embodiments of the present disclosure. FIGs. 2A to 2D are cross-sectional views of the laser structure 200 at various process stages in accordance with some embodiments of the present disclosure. The method 100 includes steps S110-S160. It should be understood that additional steps may be added before, during, and after the steps S110-S160, and some of steps described below can be replaced or eliminated for another embodiment of the method. The order of the steps/processes may be interchangeable.

First, reference is made to FIGs. 1 and 2A. The method 100 begins at step S110. A semiconductor layer 220 is formed on a conductive substrate 210. For example, in the present embodiment, the semiconductor layer 220 may be formed on the conductive substrate 210 by a metal-organic chemical vapor deposition (MOCVD) process, the like, or a combination thereof.

The semiconductor layer 220 is made of the same material as the conductive substrate 210. For example, the conductive substrate 210 may be made of semiconductor materials, such as silicon (Si), germanium (Ge), silicon carbide (SiC), gallium arsenide (GaAs), gallium nitride (GaN), indium phosphide (InP), the like or a combination thereof. The semiconductor layer 220 may be made of GaAs. In other embodiments, the semiconductor layer 220 may be made of a material (such as aluminum gallium arsenide (AlGaAs)) different from that of the conductive substrate 210.

Furthermore, a configuration of the semiconductor layer 220 may be adjusted according to functional requirements. For example, in the present embodiment, the semiconductor layer 220 has a multi-layer repetitive structure, thereby forming a distributed Bragg reflector (DBR). A conductive type of the semiconductor layer 220 may be adjusted according to functional requirements. For example, in the present embodiment, the conductive type of the semiconductor layer 220 may be N type.

After the step S110, the method 100 proceeds to the step S120. An active layer 230 is formed on the semiconductor layer 220, in which the active layer 230 is excited by electric energy to produce a laser beam. For example, in some embodiments, the active layer 230 may be formed on the semiconductor layer 220 by the MOCVD process, the like or a combination thereof, in which the active layer 230 may include multiple layers of a film layer (not illustrated) configured to form a multiple quantum well (MQW). Materials of the active layer 230 may be determined according to a wavelength of the laser beam to be produced. For example, in some embodiments, the active layer 230 may be made of indium gallium phosphide (InGaP), indium gallium arsenide (InGaAs), the like or a combination thereof.

After the step S120, the method 100 proceeds to the step S130. A semiconductor layer 240 is formed on the active layer 230, in which the active layer 230 separates the semiconductor layer 240 from the semiconductor layer 220. For example, in some embodiments, the semiconductor layer 240 may be formed on the active layer 230 by the MOCVD process, the like or a combination thereof. The semiconductor layer 240 may be made of materials including aluminum and semiconductor materials, such as AlGaAs.

Furthermore, a configuration of the semiconductor layer 240 may be adjusted according to functional requirements. For example, in the present embodiment, the semiconductor layer 240 has a multi-layer repetitive structure, thereby forming the DBR. A conductive type of the semiconductor layer 240 may be adjusted according to functional requirements. For example, in the present embodiment, the conductive type of the semiconductor layer 240 is different from the semiconductor layer 220. The conductive type of the semiconductor layer 240 may be individually designed as P type doping. In another embodiment, the conductive type of the semiconductor layer 240 is the same as that of the semiconductor layer 220. The conductive type of the semiconductor layer 240 may be designed as N type doping in combination with a tunneling junction.

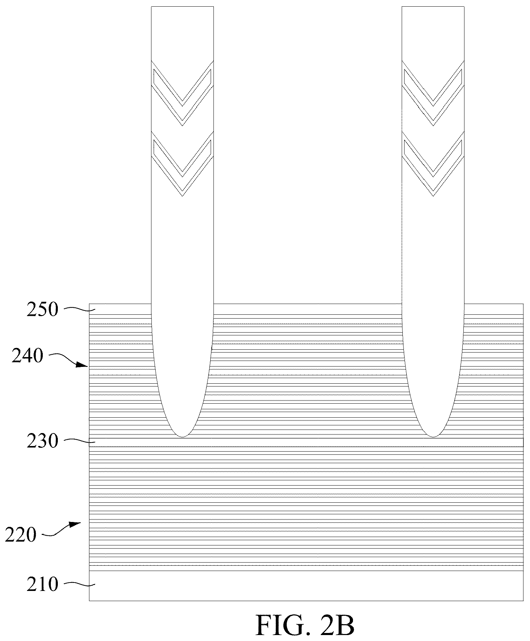

Reference is also made to FIG. 2B. After the step S130, the method 100 proceeds to the step S140. A dielectric layer 250 is formed on the semiconductor layer 240. For example, in some embodiments, the dielectric layer 250 may be disposed on the semiconductor layer 240 by a plasma enhanced chemical vapor deposition (PECVD) process, a sputtering process ,an atomic layer deposition process (ALD), an electron beam-induced deposition process (EBID), the like or a combination thereof. The dielectric layer 250 is made of inorganic oxides, inorganic nitrides, inorganic nitrogen oxides, and a combination of multiple layers thereof. For example, in some embodiments, the dielectric layer 250 may be silicon dioxide (SiO₂), silicon nitride (Si₃N₄), or aluminum oxide (Al₂O₃). Therefore, the dielectric layer 250 may be disposed on the semiconductor layer 240 to prevent the semiconductor layer 240 from being oxidized.

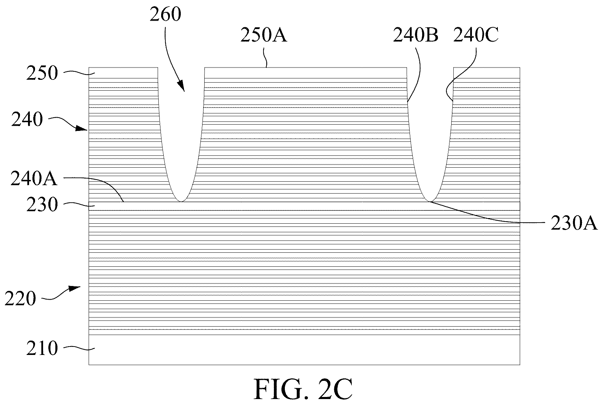

Reference is also made to FIG. 2C. After the step S140, the method 100 proceeds to the step S150. Plural blind via holes 260 are formed in the semiconductor layer 240. For example, in present embodiment, the semiconductor layer 240 and the dielectric layer 250 may be irradiated by an ultra-short pulse laser, and predefined periodic holes may be formed in the semiconductor layer 240 and the dielectric layer 250 by a strong non-linear effect of the ultra-short pulse laser. Physical or chemical changes such as dissociation may occur in regions of the semiconductor layer 240 that is irradiated by the focused ultra-short pulse laser due to the strong non-linear effect, thereby transforming materials of the regions of the semiconductor layer 240 from semiconductor materials into a hole structure. Therefore, the blind via holes 260 may be formed in the semiconductor layer 240 and the dielectric layer 250. In some embodiments, the blind via holes 260 may be formed in the semiconductor layer 240 and the dielectric layer 250 by a femtosecond laser, a focus ion beam (FIB), a dry etching process, a photolithography process in combination with an inductively coupled plasma (ICP), the like or a combination thereof.

Furthermore, the blind via holes 260 extend from a top surface 250A of the dielectric layer 250 to a bottom surface 240A of the semiconductor layer 240, in which the blind via holes 260 expose a top surface 230A of the active layer 230 and opposite side surfaces 240B and 240C of the semiconductor layer 240. In other words, the blind via holes 260 penetrate through the semiconductor layer 240 and the dielectric layer 250. Therefore, the blind via holes 260 may replace conventional annular trenches, and have advantages such as preventing failure of a component resulting from a fracture of a metal, reducing costs of materials and processes, and increasing heat dissipation efficiency of the component.

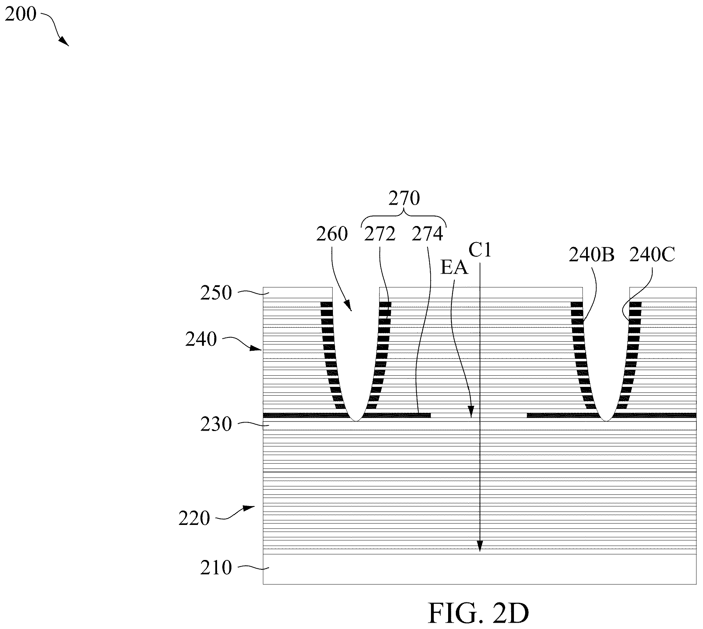

Reference is also made to FIG. 2D. After the step S150, the method 100 proceeds to the step S160. An oxide insulation layer 270 is formed in the semiconductor layer 240 and the blind via holes 260 to obtain the laser structure 200. For example, in present embodiment, a selective wet oxidation process may be performed to the side surfaces 240B and 240C of the semiconductor layer 240 exposed by the blind via holes 260, and the side surfaces 240B and 240C of the semiconductor layer 240 exposed by the blind via holes 260 permeates towards the semiconductor layer 240 to form the oxide insulation layer 270.

Furthermore, in the present embodiment, the oxide insulation layer 270 has portions 272 and portions 274. The portions 272 of the oxide insulation layer 270 are above the portions 274 of the oxide insulation layer 270. The portions 274 of the oxide insulation layer 270 are in a first pair of the DBR of the semiconductor layer 240 adjacent to the active layer 230. Lengths of the portions 272 and 274 of the oxide insulation layer 270 are affected by an oxidation rate of the semiconductor layer 240. For example, aluminum content of the first pair of the DBR of the semiconductor layer 240 adjacent to the active layer 230 is greater than other pairs of the DBR of the semiconductor layer 240 away from the active layer 230, so that the oxidation rate of the first pair of the DBR is greater than that of other pairs of the DBR, thereby allowing the portions 274 of the oxide insulation layer 270 to extend beyond the portions 272 of the oxide insulation layer 270. In other words, the length of the portions 274 of the oxide insulation layer 270 is greater than the length of the portions 272 of the oxide insulation layer 270. However, it should be noticed that configurations of the oxide insulation layer 270 are not limited thereto, and the configurations of the oxide insulation layer 270 may be adjusted according to functional requirements. For example, in some embodiments, the portions 274 of the oxide insulation layer 270 may be disposed in a second pair of the DBR of the semiconductor layer 240 to reduce diffraction effect.

In addition, the oxide insulation layer 270 may be used as a current confinement structure. For example, in the present embodiment, the portions 274 of the oxide insulation layer 270, the semiconductor layer 240, and the active layer 230 form a light emitting region EA, in which the light emitting region EA is between the portions 274 of the oxide insulation layer 270, and the blind via holes 260 surround the light emitting region EA. In detail, the oxide insulation layer 270 separates part of the semiconductor layer 240 from the active layer 230, and due to a higher resistance of the oxide insulation layer 270, the semiconductor layer 220, the active layer 230, and the semiconductor layer 240 may only form a conducting path at a specified location (for example, the light emitting region EA) to flow a current C1. Therefore, a flow direction of the current C1 of the laser structure 200 may be confined, thus preventing the laser structure 200 from producing the leakage current.

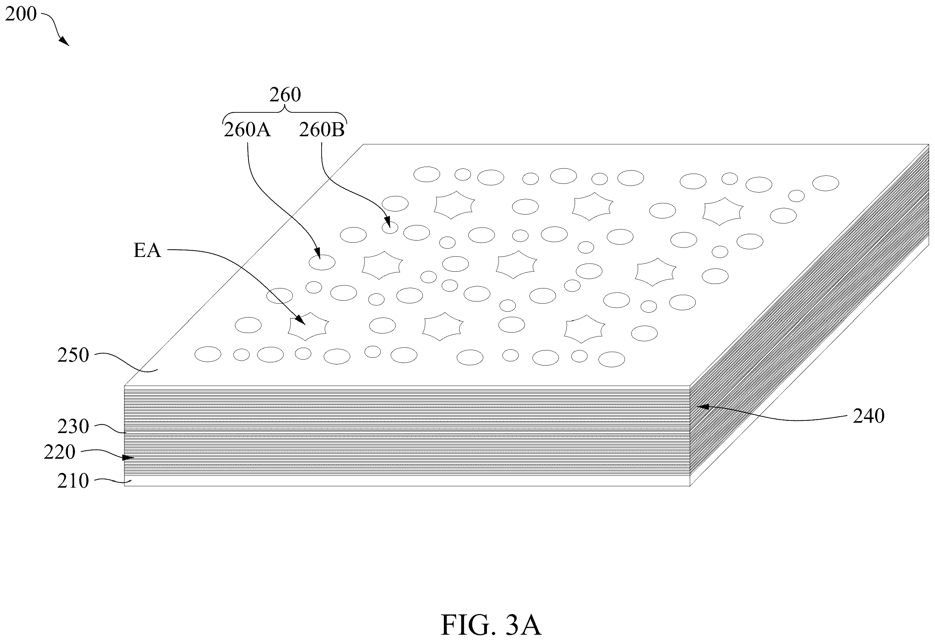

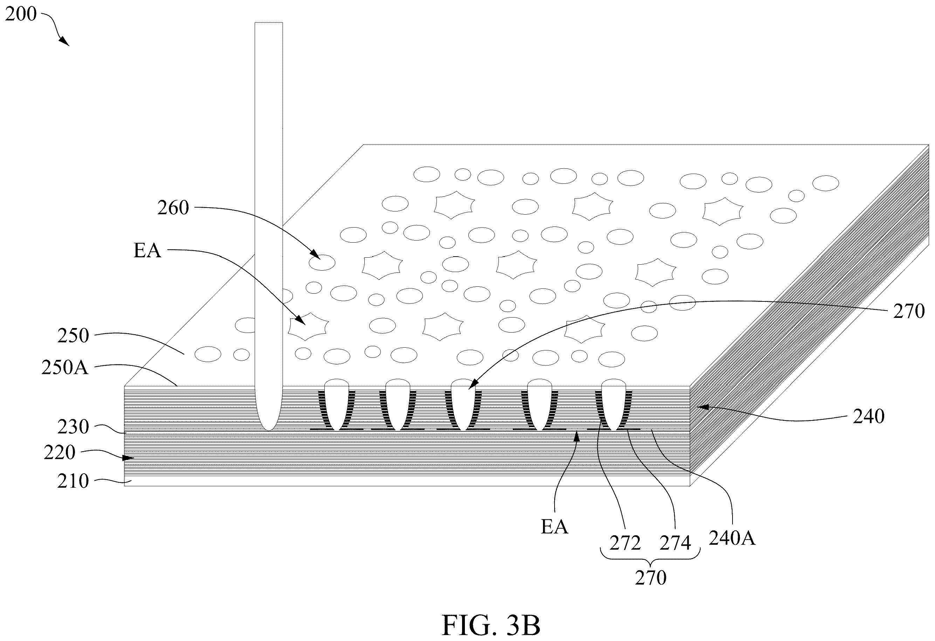

Reference is also made to FIGs. 3A and 3B. FIGs. 3A and 3B are schematic diagrams of the laser structure 200 in accordance with some embodiments of the present disclosure. The configuration of the blind via holes 260 may be adjusted according to functional requirements. For example, in the present embodiment, the laser structure 200 may be applied to an surface-emitting laser (SEL) array, the like or a combination thereof, in which the blind via holes 260 include plural blind via holes 260A and 260B, in which the blind via holes 260B are between the blind via holes 260A, and the blind via holes 260A and 260B are substantially the same. Therefore, the blind via holes 260 may not only be disposed around the light emitting region EA (for example, the blind via holes 260A), but also be disposed between the light emitting regions EA (for example, the blind via holes 260B). Accordingly, the laser structure 200 may achieve a quasi-planar effect to effectively avoid the leakage current path between the blind via holes, thus preventing the leakage current.

In some embodiments, the laser structure 200 may be applied to a single surface-emitting laser (SEL), the like, or a combination thereof, in which the blind via holes 260 may be disposed and replace multiple light emitting regions EA, and only one light emitting region EA is remained. Accordingly, the laser structure 200 may achieve a quasi-planar effect to effectively avoid the leakage current path between the blind via holes, thus preventing the leakage current.

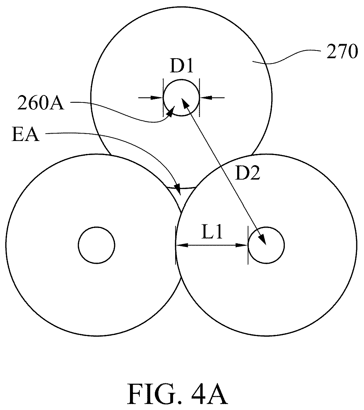

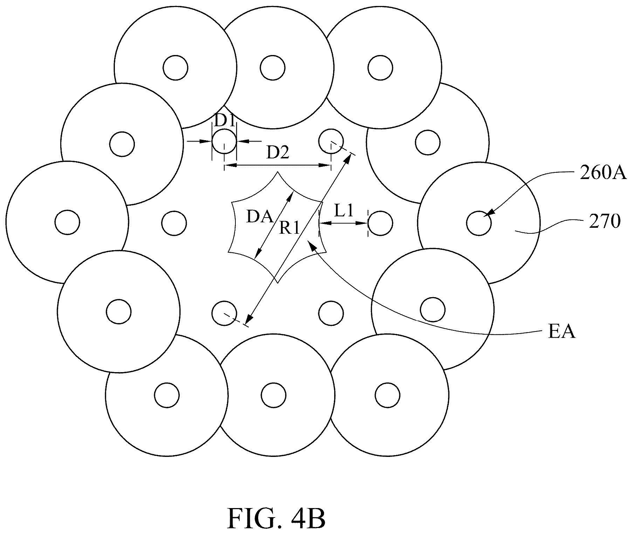

Reference is also made to FIGs. 4A and 4B. FIGs. 4A and 4B are schematic diagrams of arrangements of the blind via holes 260A of the laser structure 200 in accordance with some embodiments of the present disclosure. The arrangements of the blind via holes 260A may be adjusted according to functional requirements, in which an oxide aperture DA of the light emitting region EA is related to the arrangements of the blind via holes 260A, and a shape of the light emitting region EA is defined by the arrangements of the blind via holes 260A. For example, in the present embodiment, the blind via holes 260A substantially arranged in equilateral triangles are used as an example, and the shape of the light emitting region EA is substantially similar to the equilateral triangle. In addition, the blind via holes 260A around the light emitting region EA are required to match a formula A1. The formula A1 is: $D 1 < D 2 < 2 \times L 1 + D 1 ,$ where D1 is a diameter of the blind via holes 260A or the blind via holes 260B, D2 is distance between the adjacent two of blind via holes 260A or the adjacent two of blind via holes 260B, and L1 is an oxide depth of the oxide insulation layer 270 facing towards the semiconductor layer 240. The oxide aperture DA of the light emitting region EA is required to match a formula A2. The formula A2 is: $DA = \left(\frac{D 1}{2}+L1\right) \times \left(\sqrt{3}-\frac{3}{2}\right) .$ Furthermore, the blind via holes 260B outside the light emitting region EA are required to match the formula A1 and a formula A3, in which the formula A3 is: $\left(\frac{D 1}{2}+L1\right) > \frac{D 2}{\sqrt{3}} .$ Therefore, the oxide insulation layer 270 may ensure to be sealed completely to block the leakage current path.

In another embodiment, the blind via holes 260A arranged in N-gons are used as an example, and the shape of the light emitting region EA is substantially similar to the N-gon. In addition, the blind via holes 260A around the light emitting region EA are required to match a formula A4, in which N is a positive integer greater than 4. The formula A4 is: $D 1 < D 2 < 2 \times L 1 + D 1 < R 1 ,$ where R1 is a maximum distance between the blind via holes 260A around the light emitting region EA. The oxide aperture DA of the light emitting region EA is required to match a formula A5. The formula A5 is: $DA ≒ R 1 - D 1 - 2 \times L 1 .$ Therefore, the oxide insulation layer 270 may ensure to be sealed completely to block the leakage current path.

In one aspect of the present disclosure, a laser structure is provided. The laser structure uses a ring configuration of blind via holes to replace conventional annular etched trenches. Therefore, it may effectively prevent failure of a component resulting from a fracture of a metal in a subsequent wiring process. The annular blind via holes of the laser structure is not limited to be fabricated by an etching process. Therefore, it may significantly reduce costs of materials and processes, and increase heat dissipation efficiency of the component. Furthermore, the annular blind via holes are not limited to be formed at a position of the optical window. The annular blind via holes may be formed at positions other than the position of the optical window. Therefore, it may achieve a quasi-planar effect to avoid a leakage current path between the blind via holes with the ring configuration, thus preventing the leakage current.

## Claims

1. A method (100) for fabricating a laser structure (200), comprising:
forming a first semiconductor layer (220) on a conductive substrate (210);
forming an active layer (230) on the first semiconductor layer (220);
forming a second semiconductor layer (240) on the active layer (230);
forming a dielectric layer (250) on the second semiconductor layer (240);
forming a plurality of blind via holes (260) in the second semiconductor layer (240); and
forming an oxide insulation layer (270) in the second semiconductor layer (240) and the blind via holes (260) to obtain the laser structure (200), wherein the blind via holes (260) extend from a top surface (250A) of the dielectric layer (250) to a bottom surface (240A) of the second semiconductor layer (240), and the blind via holes (260) expose a top surface (230A) of the active layer (230).

2. The method of claim 1, wherein a conductive type of the first semiconductor layer (220) is the same as a conductive type of the second semiconductor layer (240).

3. The method of claim 1, wherein a conductive type of the first semiconductor layer (220) is different from a conductive type of the second semiconductor layer (240).

4. The method of claim 1, wherein a conductive type of the second semiconductor layer is P type doping or N type doping in combination with a tunneling junction.

5. The method of claims 2 or 3, wherein the active layer (230) separates the second semiconductor layer (240) from the first semiconductor layer (220).

6. The method of claim 1, wherein the oxide insulation layer (270) has first portions (272) and second portions (274), and the second portions (274) extend beyond the first portions (272).

7. The method of claim 6, wherein the second portions (274) of the oxide insulation layer (270), the second semiconductor layer (240), and the active layer (230) form a light emitting region (EA).

8. The method of claims 6 or 7, wherein the light emitting region (EA) is between the second portions (274) of the oxide insulation layer (270).

9. The method of claim 1, wherein the blind via holes (260) comprise a plurality of first blind via holes (260A) and second blind via holes (260B), wherein the second blind via holes (260B) are between the first blind via holes (260A).

10. The method of claim 9, wherein the oxide insulation layer (270) has first portions (272) and second portions (274), and the second portions (274) of the oxide insulation layer (270), the second semiconductor layer (240), and the active layer (230) form a light emitting region (EA), wherein the first blind via holes (260A) surround the light emitting region (EA).

11. A laser structure (200), comprising:
a conductive substrate (210);
a first semiconductor layer (220) disposed on the conductive substrate (210);
an active layer (230) disposed on the first semiconductor layer (220);
a second semiconductor layer (240) disposed on the active layer (230);
a dielectric layer (250) disposed on the second semiconductor layer (240);
a plurality of blind via holes (260) extending from a top surface (250A) of the dielectric layer (250) to a bottom surface (240A) of the second semiconductor layer (240), wherein the blind via holes (260) expose a top surface (230A) of the active layer (230); and
an oxide insulation layer (270) in the second semiconductor layer (240) and the blind via holes (260).

12. The laser structure of claim 11, wherein the oxide insulation layer (270) has first portions (272) and second portions (274), and the second portions (274) extend beyond the first portions (272).

13. The laser structure of claims 11 or 12, wherein the second portions (274) of the oxide insulation layer (270), the second semiconductor layer (240), and the active layer (230) form a light emitting region (EA).

14. The laser structure of claim 13, wherein the light emitting region (EA) is between the second portions (274) of the oxide insulation layer (270).

15. The laser structure of claim 13, wherein the blind via holes (260) comprise a plurality of first blind via holes (260A) and second blind via holes (260B), wherein the second blind via holes (260B) are between the first blind via holes (260A).

16. The laser structure of claim 15, wherein the first blind via holes (260A) surround the light emitting region (EA).

17. The laser structure of claim 15, wherein the first blind via holes (260A) are arranged in a plurality of equilateral triangles.

18. The laser structure of claim 15, wherein the first blind via holes (260A) are arranged in a plurality of N-gons, and N is a positive integer greater than 4.

19. The laser structure of claim 15, wherein an arrangement of the first blind via holes (260A) defines a shape of the light emitting region (EA).

20. The laser structure of claim 15, wherein an oxide aperture (DA) of the light emitting region (EA) matches: $DA ≒ R 1 - D 1 - 2 \times L 1 ,$ where DA is the oxide aperture, D1 is a diameter of each of the first blind via holes (260A) or the second blind via holes (260B), and L1 is an oxide depth of the oxide insulation layer (270) facing towards the second semiconductor layer (240).

21. The laser structure of claim 15, wherein the first blind via holes (260A) and the second blind via holes (260B) match: $D 1 < D 2 < 2 \times L 1 + D 1 ,$ where D1 is a diameter of each of the first blind via holes (260A) or the second blind via holes (260B), D2 is a distance between adjacent two of the first blind via holes (260A) or the adjacent two of second blind via holes (260B), and L1 is an oxide depth of the oxide insulation layer (270) facing towards the second semiconductor layer (240).
